# EUROPEAN PATENT APPLICATION

(11) **EP 4 718 862 A1**
(43) Date of publication of application: **01.04.2026**
(21) Application number: 25205338.4
(22) Date of filing: 29.09.2025
(51) Int. Cl.: H04Q 1/02, H05K 7/14

(54) **DATA CENTER RACK WITH INTEGRATED MANIFOLD AND POWER DISTRIBUTION**

(30) Priority: 27.09.2024 US 202463700307 P; 26.09.2025 US 202519342048
(71) Applicant: Vertiv Corporation, Westerville, OH 43082 (US)
(72) Inventor: POPE, Alexander, Westerville, 43082 (US); LIU, Xin, Westerville, 43082 (US)
(74) Representative: Bryn-Jacobsen, Caelia

(57) **Abstract**

A data center rack integrates power and/or fluid coolant distribution to servers, switches and other information technology (IT) devices within the rack via power distribution units (PDU) and rack manifolds integrated into the support columns of the rack structure. For example, the integrated PDUs are connectible to a power source via connection ports on an exterior surface of the rack, the PDU configurable within the rack to maximize available space and minimize the need for additional power cabling. Similarly, the integrated rack manifold is connectable to a coolant supply device or system via external manifold connection ports and provides integrated coolant tubing for thermal management of IT devices mounted within the rack. By optimizing the available airspace within the interior cavity of the rack, the integrated power and manifold systems facilitate heat dissipation and routine maintenance.

## Description

### CROSS-REFERENCE TO RELATED APPLICATIONS

The present application claims the benefit under 35 U.S.C. § 119(e) of U.S. Provisional Patent Application Serial Number 63/700,307 filed September 27, 2024, titled DATA CENTER RACK WITH INTEGRATED MANIFOLD AND POWER DISTRIBUTION. Said U.S. Provisional Patent Application 63/700,307.

### TECHNICAL FIELD

The present disclosure is directed generally to the field of power distribution, and more particularly to devices and components for power distribution in information technology (IT) environments.

### BACKGROUND

As the density of servers, switches, and other IT equipment deployed in single-rack environments continues to increase, larger capacity power distribution units (PDUs) are needed to power this equipment. Similarly, as the heat generated by IT devices increases in line with their density, server racks will require liquid cooling in order to operate effectively, which in turn will require the installation of manifolds and piping for liquid cooling in the server racks. Larger-capacity PDUs require higher capacity power cables with larger diameters, direct-to-chip (D2C) liquid cooling requires more pipe connections, and both these cables and these pipes require sufficient bending radius within the rack. Greater bending radii for power cables and cooling pipes translates to more occupied space within the rack environment, which complicates daily maintenance and frustrates heat dissipation.

### BRIEF DESCRIPTION OF THE DRAWINGS

The detailed description is described with reference to the accompanying figures. The use of the same reference numbers in different instances in the description and the figures may indicate similar or identical items. Various examples or examples ("examples") of the present disclosure are disclosed in the following detailed description and the accompanying drawings. The drawings are not necessarily to scale. In general, operations of disclosed processes may be performed in an arbitrary order, unless otherwise provided in the claims. In the drawings:
FIG. 1 is overhead view of a server rack incorporating integrated manifold and power distribution according to example examples of the inventive concepts disclosed herein;
FIG. 2 is an overhead view of the server rack of FIG. 1 incorporating additional power connection and manifold connection ports;
FIGS. 3A and 3B are respectively left-side and right-side isometric views of the server rack of FIG. 1, showing the integrated manifold distribution according to example examples of the inventive concepts disclosed herein; and
FIGS. 4A and 4B are respectively a right-side and left-side isometric views of the server rack of FIG. 1, showing the integrated power distribution according to example examples of the inventive concepts disclosed herein.

### SUMMARY

In a first aspect, a data center rack or server rack installable in a data center environment and incorporating integrated power supply connectivity is disclosed. In examples, the server rack may include a rack structure for supporting servers, switches, and/or other information technology (IT) devices mounted therein. For example , the rack structure may include a set of rack columns (e.g., four rack columns, assuming a server rack of rectangular shape spaced apart) and top and bottom external surfaces. A power distribution unit (PDU; also rack PSU (rPDU)) may be integrated into one or more rack columns, the IT devices pluggable into the PDU to receive operating power. In examples, the server rack may include a power connection port on a external surface, the power connection port capable of connecting the PDU to a power source by attaching a power cable to the port.

In some examples, each PDU includes a series of sockets, each IT device pluggable into a socket to receive operating power via the PDU. For example, sockets may be vertically adjustable relative to the PDU, e.g., in order to minimize the internal cabling necessary to connect an IT device to the PDU socket.

In some examples, the PDU may include a busbar. For example, the power sockets may be set into or may extend along the busbar, and the busbar may extend partially or fully along the height of the PDU. Further, IT devices may be connectible directly to the PDU via the busbar in order to receive operating power.

In some examples, the external surfaces include a top surface, e.g., a roof of the server rack, or a bottom surface, e.g., a floor of the server rack.

In a further aspect, a data center rack or server rack incorporating integrated chiller system connectivity is disclosed. In some examples, the server rack includes a plurality of rack columns spaced apart in a rectangular array, e.g., at the four corners of the rack. A rack manifold may be integrated into one or more of the rack columns, such that the rack manifold provides internal coolant tubing connectible to servers, switches, and/or information technology (IT) devices mounted within the rack and capable of circulating a liquid coolant proximate to or through the devices. The server rack may include a pair of manifold connection ports integrated into an external surface of the rack, each pair including a coolant supply port and a coolant return port and connectible to a coolant distribution unit (CDU) capable of supplying the liquid coolant to be circulated through the server rack via the internal coolant tubing to absorb and remove heat generated by the IT devices mounted to the rack.

In some examples, internal coolant tubing includes pairs of coolant supply tubing connected to the coolant supply port and coolant return tubing connected to the coolant return port, via which the liquid coolant may be internally circulated through the server rack.

In some examples, the external surface may be either a top or bottom surface, e.g., a roof or floor of the server rack. For example, the manifold connection ports may be integrated into a bottom surface of the server rack, e.g., provided the server rack is sufficiently elevated above the data center floor to allow for tubing and/or cabling.

It is to be understood that both the foregoing general description and the following detailed description are exemplary and explanatory only and are not necessarily restrictive of the present disclosure. The accompanying drawings, which are incorporated in and constitute a part of the specification, illustrate subject matter of the disclosure. Together, the descriptions and the drawings serve to explain the principles of the disclosure.

### DETAILED DESCRIPTION

Before explaining one or more examples of the disclosure in detail, it is to be understood that the examples are not limited in their application to the details of construction and the arrangement of the components or steps or methodologies set forth in the following description or illustrated in the drawings. In the following detailed description of examples, numerous specific details may be set forth in order to provide a more thorough understanding of the disclosure. However, it will be apparent to one of ordinary skill in the art having the benefit of the instant disclosure that the examples disclosed herein may be practiced without some of these specific details. In other instances, well-known features may not be described in detail to avoid unnecessarily complicating the instant disclosure.

As used herein a letter following a reference numeral is intended to reference an example of the feature or element that may be similar, but not necessarily identical, to a previously described element or feature bearing the same reference numeral (e.g., 1, 1a, 1b). Such shorthand notations are used for purposes of convenience only and should not be construed to limit the disclosure in any way unless expressly stated to the contrary.

Further, unless expressly stated to the contrary, "or" refers to an inclusive or and not to an exclusive or. For example, a condition A or B is satisfied by any one of the following: A is true (or present) and B is false (or not present), A is false (or not present) and B is true (or present), and both A and B are true (or present).

In addition, use of "a" or "an" may be employed to describe elements and components of examples disclosed herein. This is done merely for convenience and "a" and "an" are intended to include "one" or "at least one," and the singular also includes the plural unless it is obvious that it is meant otherwise.

Finally, as used herein any reference to "one example" or "some examples" means that a particular element, feature, structure, or characteristic described in connection with the example is included in at least one example disclosed herein. The appearances of the phrase "in some examples" in various places in the specification are not necessarily all referring to the same example, and examples may include one or more of the features expressly described or inherently present herein, or any combination or sub-combination of two or more such features, along with any other features which may not necessarily be expressly described or inherently present in the instant disclosure.

Broadly speaking, examples of the inventive concepts disclosed herein are directed to a server rack configuration incorporating one or both of a power distribution unit (PDU) or a liquid cooling rack manifold integrated into on or more columns of the rack structure. For example, the a rack PDU (rPDU) into a column of the server rack allows any information technology (IT) devices (or other devices) housed or mounted therein to be powered via the rPDU by plugging a power source into a power connection port mounted externally to the rack structure, thereby conserving space otherwise needed for interior cabling. Similarly, the integrated rack manifold may allow connection of the server rack to a liquid cooling system by plugging the cooling system into an external manifold connection port, again providing dedicated internal piping for circulation of liquid coolant. By reducing the interior space needed for rPDU cabling and/or manifold piping, the server rack can accommodate higher densities at improved capacity for heat dissipation and provide plug-and-play integration with power distribution and thermal management systems.

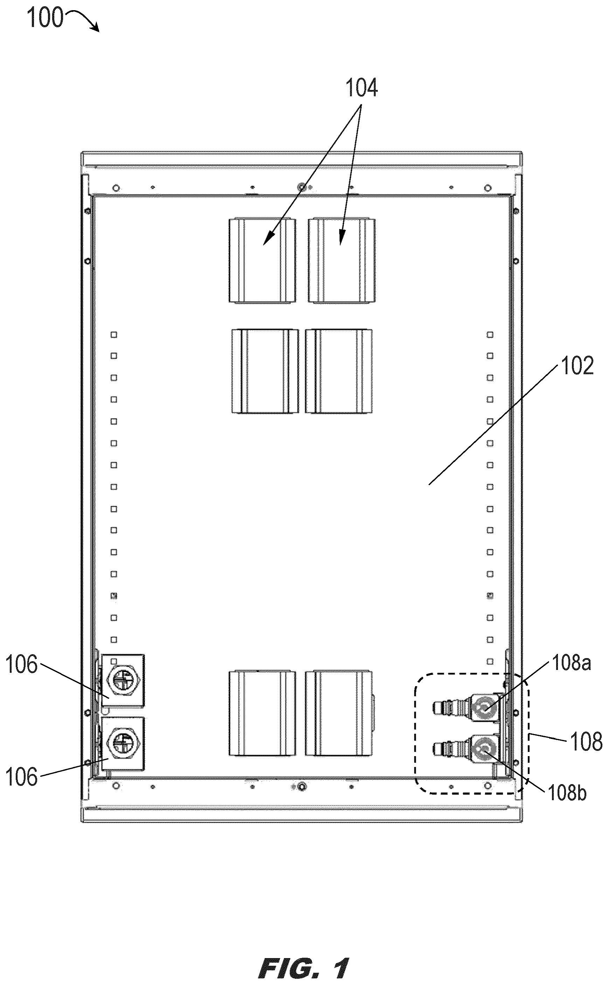

Referring to FIG. 1, a server rack 100 is shown in an overhead view.

In examples, the server rack 100 may include a roof 102, e.g., a shelf or substantially flat upper surface serving as a top end of the server rack, e.g., furthest from the floor of a data center environment within which the server rack 100 may be housed. For example, the roof 102 may connect columns of the server rack 100 as shown below, or may rest directly above the top ends of the columns supported by the columns.

In some examples, the roof 102 may include one or more removable cutouts 104. For example, removable cutouts 104 may be detached from the roof 102 to allow cabling to be run into the interior of the server rack 100. However, as the server rack 100 may integrate power distribution and/or manifold distribution into its internal structure, the need for such cabling, or for such removable cutouts 104, may be minimized or eliminated entirely.

In examples, the roof 102 may include one or more of a power connection port 106 or a manifold connection port 108. For example, each power connection port 106 may be connectible to an external power source (e.g., alternating current (AC) grid source, direct-current (DC) battery source). Further, the power connection port 106 may connect the external power source to a rack power distribution unit (PDU, rPDU) incorporated into the structure of the server rack 100 as described below, such that the rPDU may provide operating power to any servers, switches, or other information technology (IT) devices mounted within the server rack 100 and plugged into the rPDU.

In examples, the manifold connection ports 108 may comprise a set of two ports, a coolant supply port 108a and a coolant return port 108b. For example, the coolant supply and return ports 108a, 108b may be connected via supply and return piping to a liquid cooling system (e.g., single-phase, two-phase; also a coolant distribution unit (CDU) component of said cooling system) for thermal management of any IT devices mounted within the server rack 100. In examples, the coolant supply port 108a may receive liquid coolant from the liquid cooling system for circulation through the IT devices as described below. For example, the liquid coolant may be received at the coolant supply port 108a according to a flow rate and supply temperature determined by the liquid cooling system.

In examples, the coolant return port 108b may likewise be coupled to the liquid cooling system via return piping. For example, liquid coolant received at the coolant supply port 108a may be circulated through the server rack 100 and/or IT devices to absorb heat generated by the IT devices, e.g., converted from the operating power supplied to said devices. Accordingly, liquid coolant circulated through the server rack 100 and/or IT devices may be returned to the liquid cooling system via the coolant return port 108b and return piping, e.g., at a return temperature higher than the supply temperature, so that any heat absorbed from within the server rack may be removed from the data center environment and the liquid coolant returned to the server rack 100 at the predetermined supply temperature.

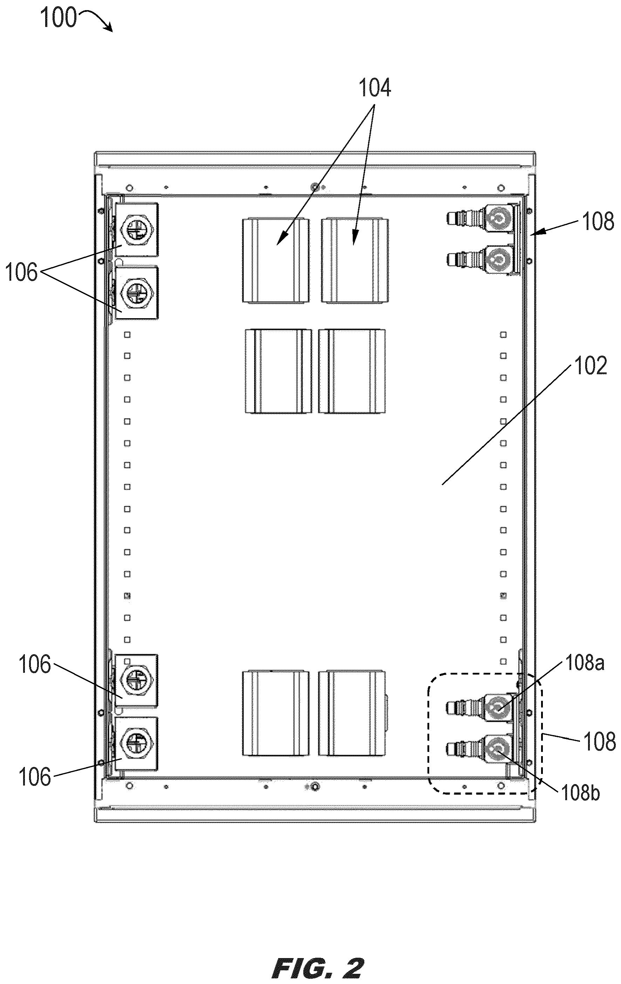

In examples, assuming a server rack 100 of rectangular shape incorporating four columns and therefore a roof 102 of rectangular shape, the server rack may include any combination of power connection port/s 106 and/or manifold connection port/s 108 as needed or determined by the power distribution and/or thermal management needs of any IT devices incorporated within the server rack, e.g., incorporated into adjacent or opposing rack columns of the server rack. For example, and referring also to FIG. 2, the roof 102 may include additional power connection ports 106 and/or additional manifold connection ports 108, each power connection port or pair of manifold connection ports 108 connected to a power distribution unit (PDU) or rack manifold as described below.

In some examples, the power connection port/s 106 and/or manifold connection port/s 108 may be incorporated into bottom surface or floor of the server rack. For example, when the server rack 100 is raised above a floor of a data center environment in which the server rack is disposed, the power connection port/s 106 and/or manifold connection port/s 108, in addition to any external cabling and/or piping necessary to connect the power or manifold connection ports to power distribution or liquid cooling systems, may be routed under the server rack.

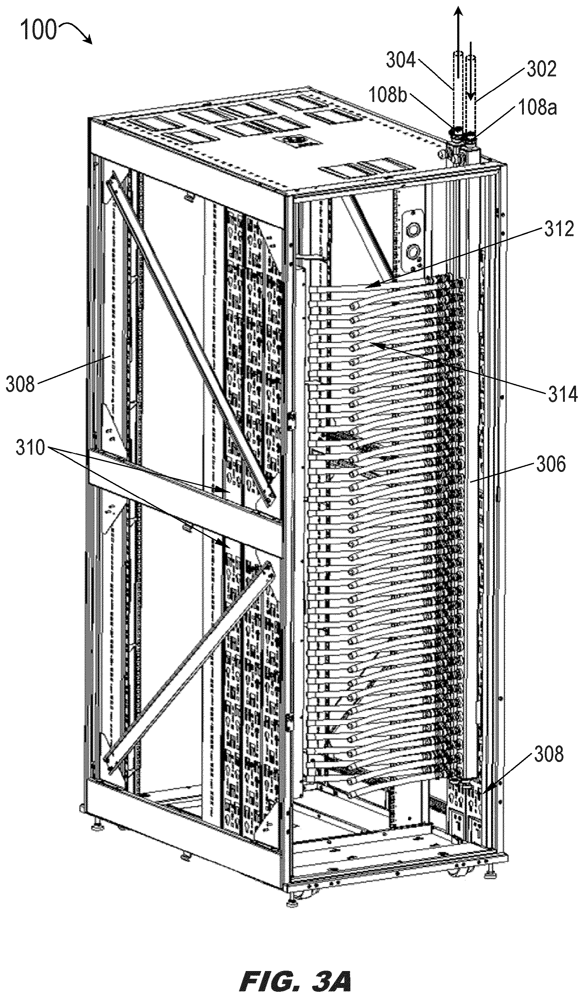

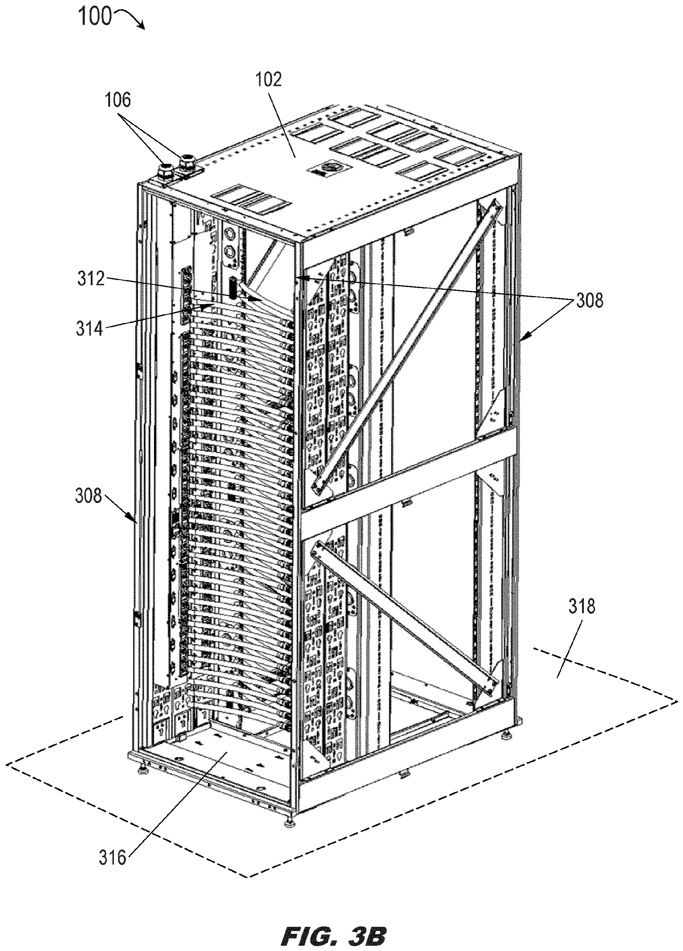

Referring now to FIGS. 3A and 3B, the manifold connection ports 108 and server rack 100 are shown.

In examples, the manifold connection port 108, e.g., the coolant supply port 108a and coolant return port 108b, may provide for connecting a liquid cooling system (not shown) by plugging supply piping 302 and return piping 304 into the coolant supply and return ports respectively. For example, liquid coolant may enter the server rack 100 via the coolant supply port 108a, where a rack manifold 306 incorporated into a column 308 of the server rack circulates the liquid coolant through IT devices 310 mounted within the server rack via internal supply piping 312 for directing the liquid coolant to the IT devices and internal return piping 314 for returning the warmer liquid coolant to the rack manifold. For example, the internal supply piping 312 and internal return piping 314 may be directly connectible to IT devices 310 or shelf-level manifolds within the server rack 100, such that no additional internal piping is needed for thermal management.

In examples, the liquid coolant, including any heat absorbed from the IT devices 310 within the server rack 100, may be returned to the liquid cooling system via the internal return piping 314, the rack manifold 306, the coolant return port 108b, and the return piping 304.

In some examples, the server rack 100 may include a floor 316 or bottom surface extending partially or fully between the rack columns 308 and parallel to the roof 102. For example, the power connection ports 106 and/or manifold connection ports 108 may be integrated into the floor 316 rather than into the roof 102 as shown by FIGS. 3A and 3B, such that the rPDU and/or rack manifold 306 extends vertically upward from the floor rather than downward from the roof. It may be noted that such configuration of the power connection ports 106 and/or manifold connection ports 108 may require sufficient spacing between the floor 316 and the floor 318 of the server room or data center environment, in order to allow adequate space for supply piping 302, return piping 304. and/or power cabling.

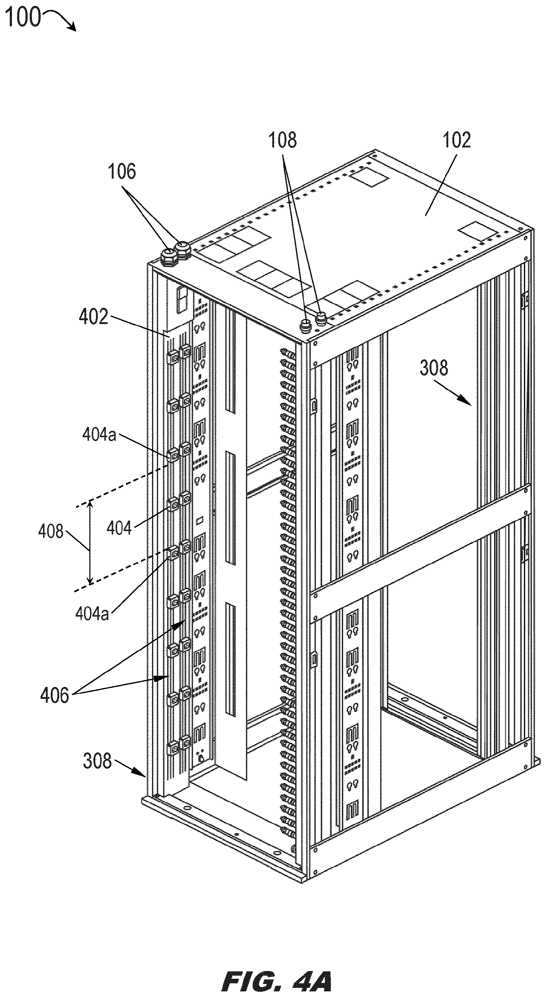

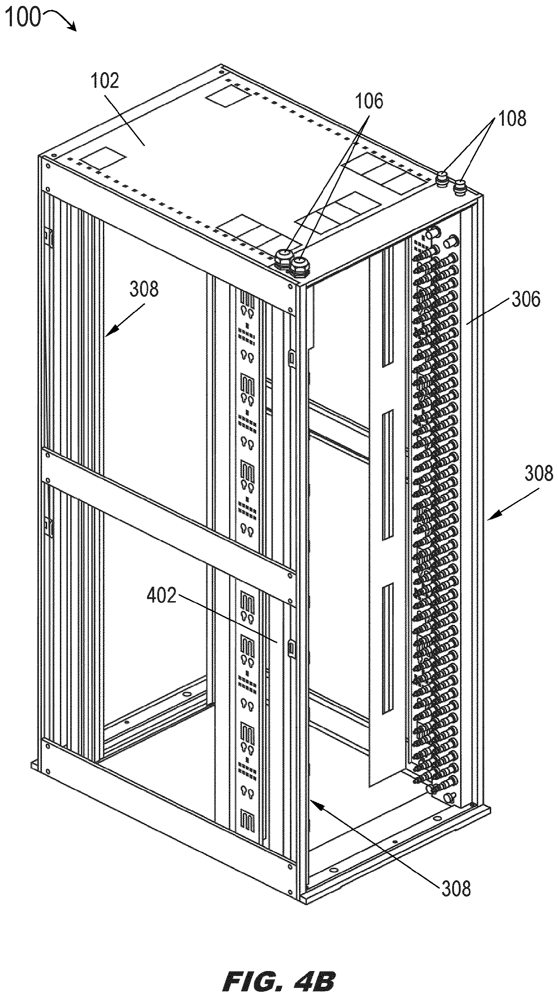

Referring now to FIGS. 4A and 4B, the server rack 100, power connection port/s 106, and manifold connection ports 108 are shown.

In examples, one or more power distribution units 402 (PDU; also rack PDU (rPDU)) may be integrated into a column 308 of the server rack 100. For example, the dimensions of the column 308 may be increased to accommodate one or more rPDUs 402 within the column; alternatively, the rPDUs 402 may be re-dimensioned, e.g., increased in width but reduced in height, for accommodation within a rack column 308 of standard dimensions. In examples, the rack manifold 306 may likewise be redimensioned to be accommodated within a rack column 308, or the rack column may be expanded to accommodate the rack manifold within its internal cavity.

In examples, each power connection port 106 may provide for respective connection of external power supply cabling to an internal rPDU 402 integrated into a column 308 of the server rack 100. In examples, each internal rPDU 402 may include a set of power sockets 404 (e.g., C20) into which any IT devices 310 (FIGS. 3A, 3B) mounted within the server rack 100 may be plugged and via which the IT devices may receive operating power. In some examples, the rPDUs 402 may incorporate one or more busbars 406 via which the IT devices 310 may receive operating power. For example, the power sockets 404 may be set into or may extend along the busbar 406 and may be adjustable relative to the busbar such that IT devices 310 may additionally connect directly to the rPDU 402 via the busbar to receive operating power. In examples, the power connection ports 106 may be sized based on, e.g., the size of the rPDU 402, such that any size power cabling may connect to the power connection ports without extending additional cable inside the server rack 100 or accommodating a bend radius of the cable.

In some examples, one or more power sockets 404 may be adjustable relative to the rPDU 402. For example, the power sockets 404 may be slidably set into the rPDU 402 such that a socket may be repositioned through a range 408 of vertical positions. In some examples, the range 408 of vertical positions to which a particular power socket 404 may be adjusted may be bounded only by adjacent power sockets 404a. By adjusting the vertical position of a power socket 404 relative to the IT device 310 plugged into the socket, the internal cabling required for power supply to the IT device may be minimized and available interior airspace within the server rack 100 optimized. In some examples, the rPDU 402 may include a mechanism for locking a power socket 404 into a vertical position, e.g., such that the socket may not be moved while operating power is fed therethrough.

### CONCLUSION

It is contemplated that examples of the inventive concepts disclosed herein may have numerous advantages. For example, as noted above, the integration of the rPDU and/or rack manifold into rack columns of the server rack, and the incorporation of external connector ports for both the rPDU and rack manifold, not only simplifies connection of a server rack to power and coolant sources (which are essentially a plug-and-play process) but conserves the limited interior space of the server rack environment. For example, with less interior space required for power cabling and/or coolant piping (e.g., based on diameter and/or bend radius), additional interior space is available for heat dissipation via passive airflow. Further, the additional interior space provided by a compact rack manifold integrated into a rack column may allow for additional operating power capacity via a likewise integrated PDU, e.g., up to 300 kW.

Those having skill in the art will recognize that the state of the art has progressed to the point where there is little distinction left between hardware and software implementations of aspects of systems; the use of hardware or software is generally (but not always, in that in certain contexts the choice between hardware and software can become significant) a design choice representing cost vs. efficiency tradeoffs. Those having skill in the art will appreciate that there are various vehicles by which processes and/or systems and/or other technologies described herein can be implemented (e.g., hardware, software, and/or firmware), and that the preferred vehicle will vary with the context in which the processes and/or systems and/or other technologies are deployed. For example, if an implementer determines that speed and accuracy are paramount, the implementer may opt for a mainly hardware and/or firmware vehicle; alternatively, if flexibility is paramount, the implementer may opt for a mainly software implementation; or, yet again alternatively, the implementer may opt for some combination of hardware, software, and/or firmware. Hence, there are several possible vehicles by which the processes and/or devices and/or other technologies described herein may be implemented, none of which is inherently superior to the other in that any vehicle to be utilized is a choice dependent upon the context in which the vehicle will be deployed and the specific concerns (e.g., speed, flexibility, or predictability) of the implementer, any of which may vary. Those skilled in the art will recognize that optical aspects of implementations will typically employ optically-oriented hardware, software, and or firmware.

The foregoing detailed description has set forth various examples of the devices and/or processes via the use of block diagrams, flowcharts, and/or examples. Insofar as such block diagrams, flowcharts, and/or examples contain one or more functions and/or operations, it will be understood by those within the art that each function and/or operation within such block diagrams, flowcharts, or examples can be implemented, individually and/or collectively, by a wide range of hardware, software, firmware, or virtually any combination thereof. In one example, several portions of the subject matter described herein may be implemented via Application Specific Integrated Circuits (ASICs), Field Programmable Gate Arrays (FPGAs), digital signal processors (DSPs), or other integrated formats. However, those skilled in the art will recognize that some aspects of the examples disclosed herein, in whole or in part, can be equivalently implemented in integrated circuits, as one or more computer programs running on one or more computers (e.g., as one or more programs running on one or more computer systems), as one or more programs running on one or more processors (e.g., as one or more programs running on one or more microprocessors), as firmware, or as virtually any combination thereof, and that designing the circuitry and/or writing the code for the software and/or firmware would be well within the skill of one of skill in the art in light of this disclosure. In addition, those skilled in the art will appreciate that the mechanisms of the subject matter described herein are capable of being distributed as a program product in a variety of forms, and that an illustrative example of the subject matter described herein applies regardless of the particular type of signal bearing medium used to actually carry out the distribution. Examples of a signal bearing medium include, but are not limited to, the following: a recordable type medium such as a floppy disk, a hard disk drive, a Compact Disc (CD), a Digital Video Disk (DVD), a digital tape, a computer memory, etc.; and a transmission type medium such as a digital and/or an analog communication medium (e.g., a fiber optic cable, a waveguide, a wired communications link, a wireless communication link, etc.).

In a general sense, those skilled in the art will recognize that the various aspects described herein which can be implemented, individually and/or collectively, by a wide range of hardware, software, firmware, or any combination thereof can be viewed as being composed of various types of "electrical circuitry." Consequently, as used herein "electrical circuitry" includes, but is not limited to, electrical circuitry having at least one discrete electrical circuit, electrical circuitry having at least one integrated circuit, electrical circuitry having at least one application specific integrated circuit, electrical circuitry forming a general purpose computing device configured by a computer program (e.g., a general purpose computer configured by a computer program which at least partially carries out processes and/or devices described herein, or a microprocessor configured by a computer program which at least partially carries out processes and/or devices described herein), electrical circuitry forming a memory device (e.g., forms of random access memory), and/or electrical circuitry forming a communications device (e.g., a modem, communications switch, or optical-electrical equipment). Those having skill in the art will recognize that the subject matter described herein may be implemented in an analog or digital fashion or some combination thereof.

Those having skill in the art will recognize that it is common within the art to describe devices and/or processes in the fashion set forth herein, and thereafter use engineering practices to integrate such described devices and/or processes into data processing systems. That is, at least a portion of the devices and/or processes described herein can be integrated into a data processing system via a reasonable amount of experimentation. Those having skill in the art will recognize that a typical data processing system generally includes one or more of a system unit housing, a video display device, a memory such as volatile and non-volatile memory, processors such as microprocessors and digital signal processors, computational entities such as operating systems, drivers, graphical user interfaces, and applications programs, one or more interaction devices, such as a touch pad or screen, and/or control systems including feedback loops and control motors (e.g., feedback for sensing position and/or velocity; control motors for moving and/or adjusting components and/or quantities). A typical data processing system may be implemented utilizing any suitable commercially available components, such as those typically found in data computing/communication and/or network computing/communication systems.

The herein described subject matter sometimes illustrates different components contained within, or connected with, different other components. It is to be understood that such depicted architectures are merely exemplary, and that in fact many other architectures can be implemented which achieve the same functionality. In a conceptual sense, any arrangement of components to achieve the same functionality is effectively "associated" such that the desired functionality is achieved. Hence, any two components herein combined to achieve a particular functionality can be seen as "associated with" each other such that the desired functionality is achieved, irrespective of architectures or intermedial components. Likewise, any two components so associated can also be viewed as being "operably connected", or "operably coupled", to each other to achieve the desired functionality, and any two components capable of being so associated can also be viewed as being "operably couplable", to each other to achieve the desired functionality. Specific examples of operably couplable include but are not limited to physically mateable and/or physically interacting components and/or wirelessly interactable and/or wirelessly interacting components and/or logically interacting and/or logically interactable components.

Further examples are set out in the items below:
1. A data center rack, comprising:
   a rack structure installable in a data center environment, the rack structure including:
   a plurality of rack columns disposed in a rectangular spaced apart relationship; and
   one or more rack shelves connecting at least two of the plurality of rack columns at a shelf height, each rack shelf configured to support at least one information technology (IT) device;
   at least one power distribution unit (PDU) integrated into a first rack column of the plurality of rack columns, the at least one IT device connectible to the at least one PDU to receive operating power therefrom;
   at least one rack manifold integrated into the rack structure, the at least one IT device connectible to the at least one rack manifold to receive a liquid coolant therefrom;
   a power connection port disposed on an external surface of the data center rack, the power connection port electrically coupled to the PDU and connectible to at least one power source via a power cable insertable into the power connection port; and
   a manifold connection port disposed on the external surface, the manifold connection port fluidly coupled to the rack manifold and connectible to a coolant distribution unit (CDU) to receive the liquid coolant therefrom.
2. The data center rack of item 1, wherein:
   each of the plurality of rack columns has a bottom end proximate to a floor of the data center environment and a top end opposite the bottom end;
      and
   wherein the PDU is integrated into the first rack column proximate to its top end.
3. The data center rack of item 2, wherein:
   the one or more rack shelves include a top shelf connecting the plurality of rack columns at their top end;
      and
   the power connection port and manifold connection port are integrated into the top shelf.
4. The data center rack of any one of the preceding items, wherein the rack manifold is integrated into a second rack column of the plurality of rack columns.
Yet further examples are set out in the clauses below:
1. A data center rack, comprising:
   a rack structure installable in a data center environment and configured to support one or more information technology (IT) devices, the rack structure including:
   a plurality of rack columns disposed in a rectangular spaced apart relationship;
      and
   at least one power distribution unit (PDU) integrated into a first rack column of the plurality of rack columns, wherein the one or more IT devices are electrically couplable to the at least one PDU to receive operating power;
      and
   a power connection port disposed on an external surface of the data center rack, wherein
   the power connection port is electrically coupled to the PDU and connectible to at least one power source via a power cable couplable to the power connection port.
2. The data center rack of clause 1, wherein:
   each PDU includes a plurality of sockets, each of the one or more IT devices electrically couplable to the at least one PDU via a socket of the plurality of sockets;
      and
   wherein the plurality of sockets includes at least one socket slidably adjustable to a plurality of vertical positions relative to the PDU.
3. The data center rack of clause 2, wherein the plurality of sockets are disposed along a busbar of the PDU;
   and
   wherein the one or more IT devices are electrically couplable to the at least one PDU via the busbar.
4.The data center rack of any one of the preceding clauses, wherein the external surface is one of a top surface or a bottom surface.
5. A data center rack, comprising:
   a rack structure installable in a data center environment and configured to support one or more information technology (IT) devices, the rack structure including:
   a plurality of rack columns disposed in a rectangular spaced apart relationship;
      and
   at least one rack manifold integrated into a first rack column of the plurality of rack columns, the at least one IT device connectible to the at least one rack manifold via one or more coolant tubes, the one or more coolant tubes configured to circulate a liquid coolant between the one or more IT devices and the rack manifold;
      and
   at least one pair of manifold connection ports disposed on an external surface of the data center rack, each pair of manifold connection ports fluidly coupled to the at least one rack manifold and connectible to a coolant distribution unit (CDU) to receive the liquid coolant via a coolant supply port and to return the circulated liquid coolant via a coolant return port.
6.The data center rack of clause 5, wherein the one or more coolant tubes include:
   a supply tube fluidly coupled to the coolant supply port;
      and
   a return tube fluidly coupled to the coolant return port.
7.The data center rack of clause 5 or 6, wherein the external surface is one of a top surface or a bottom surface.

While particular aspects of the present subject matter described herein have been shown and described, it will be apparent to those skilled in the art that, based upon the teachings herein, changes and modifications may be made without departing from the subject matter described herein and its broader aspects and, therefore, the appended claims are to encompass within their scope all such changes and modifications as are within the true scope of the subject matter described herein. Furthermore, it is to be understood that the invention is defined by the appended claims.

## Claims

1. A data center rack, comprising:
a rack structure installable in a data center environment and configured to support one or more information technology (IT) devices, the rack structure including:
a plurality of rack columns disposed in a rectangular spaced apart relationship;
and
at least one power distribution unit (PDU) integrated into a first rack column of the plurality of rack columns, wherein the one or more IT devices are electrically couplable to the at least one PDU to receive operating power;
and
a power connection port disposed on an external surface of the data center rack, wherein the power connection port is electrically coupled to the PDU and connectible to at least one power source via a power cable couplable to the power connection port.

2. The data center rack of Claim 1, wherein:
each PDU includes a plurality of sockets, each of the one or more IT devices electrically couplable to the at least one PDU via a socket of the plurality of sockets;
and
wherein the plurality of sockets includes at least one socket slidably adjustable to a plurality of vertical positions relative to the PDU.

3. The data center rack of Claim 2, wherein the plurality of sockets are disposed along a busbar of the PDU;
and
wherein the one or more IT devices are electrically couplable to the at least one PDU via the busbar.

4. The data center rack of any one of the preceding Claims, wherein the external surface is one of a top surface or a bottom surface.

5. A data center rack, comprising:
a rack structure installable in a data center environment and configured to support one or more information technology (IT) devices, the rack structure including:
a plurality of rack columns disposed in a rectangular spaced apart relationship;
and
at least one rack manifold integrated into a first rack column of the plurality of rack columns, the at least one IT device connectible to the at least one rack manifold via one or more coolant tubes, the one or more coolant tubes configured to circulate a liquid coolant between the one or more IT devices and the rack manifold;
and
at least one pair of manifold connection ports disposed on an external surface of the data center rack, each pair of manifold connection ports fluidly coupled to the at least one rack manifold and connectible to a coolant distribution unit (CDU) to receive the liquid coolant via a coolant supply port and to return the circulated liquid coolant via a coolant return port.

6. The data center rack of Claim 5, wherein the one or more coolant tubes include:
a supply tube fluidly coupled to the coolant supply port;
and
a return tube fluidly coupled to the coolant return port.

7. The data center rack of Claim 5 or 6, wherein the external surface is one of a top surface or a bottom surface.
